# EUROPEAN PATENT APPLICATION

(11) **EP 4 525 053 A1**
(43) Date of publication of application: **19.03.2025**
(21) Application number: 24800751.0
(22) Date of filing: 19.06.2024
(51) Int. Cl.: H01L 31/0224, H01L 31/18

(54) **METHOD FOR PREPARING TOPCON BATTERY, AND TOPCON BATTERY PREPARED THEREFROM**

(30) Priority: 26.07.2023 CN 202310935553
(71) Applicant: Huansheng Photovoltaic (Jiangsu) Co., Ltd, Wuxi, Jiangsu 214203 (CN)
(72) Inventor: TANG, Yiwu, Wuxi, Jiangsu 214203 (CN); LI, Suqiang, Wuxi, Jiangsu 214203 (CN); LI, Kewei, Wuxi, Jiangsu 214203 (CN); GUAN, Tongzhou, Wuxi, Jiangsu 214203 (CN); YU, Chao, Wuxi, Jiangsu 214203 (CN); SONG, Nan, Wuxi, Jiangsu 214203 (CN); WANG, Peng, Wuxi, Jiangsu 214203 (CN); WANG, Yan, Wuxi, Jiangsu 214203 (CN)
(74) Representative: Cicconetti, Andrea
(86) International application number: PCT/CN2024/100084
(87) International publication number: WO 2025/020783

(57) **Abstract**

The present invention relates to the field of solar cells, and specifically, provides a preparation method for a TOPCon cell and a TOPCon cell prepared therefrom. The preparation method for a TOPCon cell provided in the present invention includes the following steps: sequentially performing chemical nickel-plating, sintering, oxide layer removal, copper electroplating, and silver electroplating on a TOPCon solar cell substrate to obtain a TOPCon solar cell. The preparation method utilizes the technique of chemical nickel-plating combined with copper and silver electroplating to replace the traditional screen-printing technology, and the conductivity of the TOPCon substrate is enhanced after nickel-plating, which can enable double-sided copper and silver electroplating, thus significantly reducing the production cost of the battery cells. The nickel layer obtained through chemical nickel-plating has a uniform thickness and low internal stress, thus forming a strong nickel-silicon alloy after sintering. Subsequently, copper and silver are electroplated, so that the entire nickel-copper-silver coating has good adhesion to the silicon substrate, thus allowing welding pull strength to meet the requirements.

## Description

### CROSS-REFERENCE TO RELATED APPLICATIONS

The present invention claims the priority to the Chinese patent application with the filling No. 202310935553.5 filed with the Chinese Patent Office on July 26, 2023, and entitled "Preparation Method for TOPCon Cell and TOPCon Cell Prepared Therefrom", the contents of which are incorporated herein by reference in entirety.

### TECHNICAL FIELD

The present invention relates to the field of solar cells, and specifically, to a preparation method for a TOPCon battery and a TOPCon cell prepared therefrom.

### BACKGROUND ART

As a novel type of solar cell, the TOPCon solar cell has become a new hot topic in the solar energy field in recent years. The electrodes of traditional TOPCon solar cells are usually prepared by printing on the surface of silicon wafers with front and back electrodes by high-temperature silver paste using a screen-printing process. However, the sintering temperature of high-temperature silver paste exceeds 500°C, with a single-wafer consumption of 150mg/piece, which requires a higher cost.

In order to reduce costs, researchers have further proposed using electroplating processes to prepare the front and back electrodes. Typically, the first layer of nickel grid lines is formed using an electroplating nickel process, which offers a fast plating rate and a fine, smooth, and bright coating crystallization. However, this is greatly affected by the cleanliness of the silicon wafer surface and the purity of the plating solution. Additionally, due to the uneven distribution of current, the thickness of the electroplated nickel layer is uneven, and the nickel layer has high internal stress, leading to poor adhesion between the coating and the silicon substrate. The coating can be peeled off from the substrate by adhesive tape, and the welding pull strength at low temperatures also fails to meet the requirements.

CN115117186A discloses a preparation method for a TOPCon solar cell, wherein the preparation method includes the following steps: (1) independently etching grooves on the N-side and P-side of the cell substrate using laser etching, and cleaning with hydrofluoric acid; (2) sequentially depositing a nickel-phosphorus alloy layer and a first copper-tin alloy layer in the grooves on the N-side; (3) sequentially depositing a nickel-boron alloy layer and a second copper-tin alloy layer in the grooves on the P-side; and (4) performing heat treatment on the cell substrate to obtain the TOPCon cell. As described above, the electroplating nickel process has the problem of poor adhesion between the coating and the silicon substrate.

### SUMMARY

The present invention provides a preparation method for a TOPCon cell, including the following steps:
sequentially performing chemical nickel-plating, sintering, oxide layer removal, copper electroplating, and silver electroplating on a TOPCon solar cell substrate to obtain a TOPCon solar cell.

Further, the TOPCon solar cell substrate includes a silicon substrate and a coating layer deposited on the surface of the silicon substrate, and the surface of the coating layer is provided with patterned grooves.

The coating layer is a silicon nitride film.

The thickness of the silicon nitride film is 80nm-100nm.

The depth of the groove is 80nm-100nm, and the width of the groove is 10µm-60µm.

Optionally, the preparation method for the TOPCon solar cell substrate includes the following steps:
(a) coating both sides of the silicon substrate to form coating layers, and then removing the coating layers on the surface of the silicon substrate using a laser grooving method to form patterned grooves on the surface of the coating layer; and
(b) sequentially performing degreasing cleaning, oxide layer removal, and activation treatment on the patterned grooves of the silicon substrate to obtain a pretreated TOPCon solar cell substrate.

Further, in step (a), the coating method is PECVD method.

The process parameters of the PECVD method are as follows:
a pressure of 1400mTorr-1800mTorr, a temperature of 400°C-500°C, a power of 8000W-12000W, a time of 90s-120s, a pulse on-off ratio of 1: (8-10), and a volume ratio of SiH₄ to NH₃ of 1: (4-8).

Further, in step (b), the degreasing cleaning method includes the following steps:
placing the TOPCon cell substrate with patterned grooves into a degreasing solution for ultrasonic treatment, wherein
the volume percentage content of the degreasing agent in the degreasing solution is 5%-20%, and
the degreasing agent includes at least one of toluene, acetone, and ethanol; and
the process parameters for ultrasonic treatment are as follows:
   an ultrasonic temperature of 30°C-40°C, an ultrasonic time of 30s-120s, and an ultrasonic power of 60W-120W.

Further, in step (b), the oxide layer removal method includes the following steps:
soaking the degreased TOPCon cell substrate in an oxide layer removal solution, wherein
the oxide layer removal solution includes the following components by weight part:
   0.1-5 parts of ammonium fluoride, 1-10 parts of hydrofluoric acid, and 100-200 parts of water; and
   the soaking temperature in the oxide layer removal solution is 25°C-35°C, and the soaking time is 30s-90s.

Further, in step (b), the activation treatment method includes the following steps:
soaking the TOPCon cell substrate, after oxide layer removal, in an activation solution, wherein
the activation solution includes the following components by weight part:
   0.001-0.005 parts of activator, and 100-200 parts of water;
   the activator is a noble metal chloride;
   the noble metal chloride is selected from at least one of gold chloride, palladium chloride, and platinum chloride; and
   the soaking temperature in the activation solution is 25°C-35°C, and the soaking time is 60s-120s.

Further, the chemical nickel-plating method includes the following steps:
placing the TOPCon solar cell substrate in a chemical nickel-plating solution for heat treatment, wherein
the heat treatment temperature is 90°C-100°C, and the heat treatment time is 2min-5min; and
the chemical nickel-plating solution includes the following components by weight part:
   1-5 parts of nickel salt, 1-5 parts of reducing agent, 5-20 parts of complexing agent, and 100-200 parts of water;
   the nickel salt is selected from at least one of nickel sulfate, nickel chloride, and nickel aminosulfonate;
   the reducing agent is selected from at least one of sodium hypophosphite, sodium borohydride, and borane;
   the complexing agent includes sodium citrate and ammonium hydroxide, wherein a mass ratio of the sodium citrate to the ammonium hydroxide is (1-2): (5-15); and
   the pH of the chemical nickel-plating solution is 8.5-9.5.

Further, the process parameters for sintering are as follows:
a heating rate of 5°C/s-10°C/s, a sintering temperature of 280°C-360°C, and a sintering time of 60s-120s.

Further, the oxide layer removal method includes the following steps:
soaking the sintered TOPCon solar cell substrate in an oxide layer removal solution, wherein
the oxide layer removal solution is an aqueous acid solution, and the acid percentage content in the aqueous acid solution is 2%-6% by volume;
the acid is selected from at least one of hydrofluoric acid, sulfuric acid, hydrochloric acid, and nitric acid; and
the soaking temperature is 25°C-35°C, and the soaking time is 30s-60s.

Further, the copper electroplating method includes the following steps:
placing the TOPCon cell substrate, after oxide layer removal, into a copper electroplating solution and applying current for copper electroplating, wherein
the copper electroplating solution includes the following components by weight part:
   1-10 parts of copper salt, 0.5-3 parts of acid, and 20-40 parts of water;
   the copper salt includes copper sulfate and copper chloride, and a mass ratio of the copper sulfate to the copper chloride is (400-600): (0.1-0.5); and
   the acid is sulfuric acid.

Further, the process parameters for copper electroplating are as follows:
a current density of 5A/dm²-10A/dm², and an electroplating time of 5min-10min.

Further, the silver electroplating method includes the following steps:
placing the copper-plated TOPCon cell substrate into a silver electroplating solution and applying current for silver electroplating.

Further, the silver electroplating solution includes the following components by weight part:
0.1-1 part of silver salt, 0.5-3 parts of acid, 0.5-5 parts of ammonium salt, and 20-40 parts of water;
the silver salt is silver nitrate; and
the acid is sulfosalicylic acid.

Further, the process parameters for silver electroplating are as follows:
a current density of 1A/dm²-2A/dm², and an electroplating time of 15s-30s.

The present invention further provides the TOPCon cell prepared by the above preparation method.

### BRIEF DESCRIPTION OF DRAWINGS

In order to more clearly illustrate the specific embodiments of the present invention or the technical solution in the prior art, the drawings required to be used in the description of the specific embodiment or the prior art will be briefly introduced as follows. Obviously, the drawings described below are some embodiments of the present invention. Those of ordinary skill in the art, without paying inventive labor, may also obtain other drawings according to these drawings.

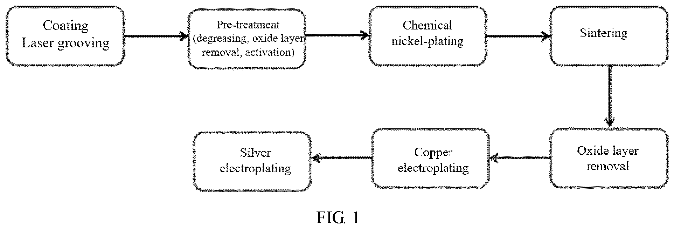

FIG 1 shows a process flow of a preparation method for a TOPCon cell.

### DETAILED DESCRIPTION OF EMBODIMENTS

The embodiments of the present invention will be described in detail below in conjunction with embodiments. However, it will be understood by those skilled in the art that the following embodiments are intended to illustrate the present invention only and should not be considered as limiting the scope of the present invention. Unless specified under particular conditions in the embodiments, standard conditions or conditions recommended by the manufacturer are used.

The present invention, in order to solve one of the technical problems in the prior art, provides a preparation method for a TOPCon cell, including the following steps:
sequentially performing chemical nickel-plating, sintering, oxide layer removal, copper electroplating, and silver electroplating on a TOPCon solar cell substrate to obtain a TOPCon solar cell.

By utilizing the technique of chemical nickel-plating combined with copper and silver electroplating to replace the traditional screen-printing technology, the conductivity of the TOPCon substrate is enhanced after nickel-plating, which can enable double-sided copper and silver electroplating, thus significantly reducing the production cost of the battery cells. The nickel layer obtained through chemical nickel-plating has a uniform thickness and low internal stress, forming a strong nickel-silicon alloy after sintering. Subsequently, copper and silver are electroplated, so that the entire nickel-copper-silver coating has good adhesion to the silicon substrate, thus allowing welding pull strength to meet the requirements.

The TOPCon cell prepared by the above preparation method provided in the present invention has good working performance.

In an optional embodiment of the present invention, the TOPCon solar cell substrate includes a silicon substrate and a coating layer deposited on the surface of the silicon substrate, and the surface of the coating layer is provided with patterned grooves.

It should be noted that the patterned grooves are crisscrossed grooves, and the grooves include primary grooves and fine grooves. The width of the primary grooves can be 50µm-60µm, and the width of the fine grooves can be 10µm-15µm.

In an optional embodiment of the present invention, the TOPCon solar cell substrate is prepared by the following method:
(a) coating both sides of the silicon substrate to form coating layers, and then removing the coating layers on the surface of the silicon substrate using a laser grooving method to form patterned grooves on the surface of the coating layer; and
(b) sequentially performing degreasing cleaning, oxide layer removal, and activation treatment on the patterned grooves of the silicon substrate to obtain a pretreated TOPCon solar cell substrate.

In an optional embodiment of the present invention, in step (a), the coating method is PECVD method.

The process parameters of the PECVD method are as follows:
a pressure of 1400mTorr-1800mTorr, a temperature of 400°C-500°C, a power of 8000W-12000W, a time of 90s-120s, a pulse on-off ratio of 1: (8-10), and a volume ratio of SiH₄ to NH₃ of 1: (4-8).

In an optional embodiment of the present invention, the specific step of degreasing and cleaning in step (b) is: placing the TOPCon cell substrate with patterned grooves into a degreasing solution for ultrasonic treatment,
wherein the volume percentage content of the degreasing agent in the degreasing solution is 5%-20%, the solvent of the degreasing solution can be water, and the degreasing agent is selected from any one or a combination of at least two of toluene, acetone, or ethanol.

In an optional embodiment of the present invention, the process parameters for ultrasonic treatment are as follows: an ultrasonic temperature of 30°C-40°C, an ultrasonic time of 30s-120s, an ultrasonic power of 60W-120W.

In an optional embodiment of the present invention, the specific step of oxide layer removal in step (b) is: soaking the TOPCon cell substrate after degreasing and cleaning in an oxide layer removal solution, wherein
the soaking temperature in the oxide layer removal solution can be 25°C-35°C, the soaking time can be 30s-90s, and the oxide layer removal solution includes, by weight part, 0.1-5 parts of ammonium fluoride, 1-10 parts of hydrofluoric acid, and 100-200 parts of water.

In an optional embodiment of the present invention, the specific step of activation treatment in step (b) is: soaking the TOPCon cell substrate, after oxide layer removal, in an activation solution, wherein
the soaking temperature in the activation solution is 25°C-35°C, the soaking time is 60s-120s, the activation solution includes, by weight part, 0.001-0.005 parts of activator, and 100-200 parts of water; and the activator can be a noble metal chloride, and the noble metal chloride is selected from any one of gold chloride, palladium chloride, or platinum chloride or a combination of at least two therefrom.

In an optional embodiment of the present invention, the TOPCon solar cell substrate is prepared by the following method:
(a) coating both sides of a silicon substrate by using a PECVD method, respectively forming a silicon nitride film with a thickness of 80nm-100nm, and removing a coating layer on a surface of the silicon substrate using a laser grooving method to form patterned grooves with a depth of 80nm-100nm and a width of 10µm-60µm on the surface of the coating layer;
(b) placing the TOPCon cell substrate with the patterned grooves into a degreasing solution for ultrasonic treatment at 30°C-40°C and a power of 60W-120W for 30s-120s, followed by washing;

placing the degreased TOPCon cell substrate into an oxide layer removal solution, soaking it at 25°C-35°C for 30s-90s, followed by washing; and
placing the TOPCon cell substrate, after oxide layer removal, into an activation solution, soaking it at 25°C-35°C for 60s-120s, and then washing to obtain the pre-treated TOPCon solar cell substrate.

By using chemical soaking for degreasing and ultrasonic vibration, the oil stains and particulate contaminants on the surface of the TOPCon cell substrate are removed, thus reducing the surface tension of the substrate and improving wettability. Placing the substrate into the oxide layer removal solution can effectively remove the oxide film formed on the substrate surface. A noble metal salt is applied for activation, and after the surface of a silicon wafer is treated with activation solution, the nickel-plating efficiency is high and the utilization rate of the nickel-plating solution is high. The subsequent chemical nickel-plating layer has uniform thickness and has no defects such as streaks or excessive brightness.

In an optional embodiment of the present invention, the specific step of chemical nickel-plating is: placing the TOPCon solar cell substrate in a chemical nickel-plating solution for heat treatment, wherein the heating treatment temperature can be 90°C-100°C, and the heating treatment time can be 2min-5min.

By using the chemical nickel-plating method, a nickel layer with uniform thickness and low internal stresses can be simultaneously formed on both sides of the pre-treated TOPCon solar cell substrate, thus achieving double-sided nickel-plating. Additionally, by controlling the temperature during the chemical nickel-plating process and managing the concentration of the main salt, the reaction is maintained under normal conditions, allowing for continuous and stable thickening, thereby further enhancing the uniformity and smoothness of the chemical nickel-plating layer surface.

In an optional embodiment of the present invention, the chemical nickel-plating solution includes, by weight part, 1-5 parts of nickel salt, 1-5 parts of reducing agent, 5-20 parts of complexing agent, and 100-200 parts of water;

the nickel salt is selected from any one or combinations of at least two of nickel sulfate, nickel chloride, or nickel aminosulfonate; the reducing agent is selected from any one or combinations of at least two of sodium hypophosphite, sodium borohydride, or borane; and the complexing agent includes sodium citrate and ammonium hydroxide, wherein a mass ratio of the sodium citrate to the ammonium hydroxide can be (1-2): (5-15).

The use of the above chemical nickel-plating solution containing specific reducing agents and complexing agents offers the following advantages. Sodium hypophosphite is inexpensive, easy to control in the plating solution, and provides a good alloy plating performance. Sodium borohydride or borane can offer better reducing performance, requiring only a small amount to achieve reduction. The complexing agents can work synergistically to prevent the precipitation of the plating solution, increase the stability of the plating solution, extend its lifespan, and also improve the deposition rate at the same time. By configuring the chemical nickel-plating solution, the reaction is maintained under normal conditions, allowing for continuous and stable thickening, thereby further enhancing the uniformity and smoothness of the chemical nickel-plating layer surface.

In an optional embodiment of the present invention, the sintering is conducted in an annealing furnace, wherein
the sintering process parameters are: a heating rate of 5°C/s~10°C/s, a sintering temperature of 280°C-360°C, and a sintering time of 60s-120s.

By using the above specific sintering process parameters, nickel atoms diffuse into the silicon, and the nickel layer and silicon layer bond together. After sintering, the nickel layer forms a stronger nickel-silicon alloy with the silicon substrate, thus improving the bonding strength.

In an optional embodiment of the present invention, the specific step of oxide layer removal is: soaking the sintered TOPCon solar cell substrate in an oxide layer removal solution.

The soaking temperature in the oxide layer removal solution can be 25°C-35°C, and the soaking time can be 30s-60s. The oxide layer removal solution is an aqueous acid solution, and the acid percentage content in the aqueous acid solution can be 2%-6% by volume, wherein the acid is selected from any one or combinations of at least two of hydrofluoric acid, sulfuric acid, hydrochloric acid, or nitric acid.

In the present invention, the use of a dilute acid solution for activation treatment not only removes the oxide layer on the surface of the product but also prevents the formation of a large amount of pickling by-products from adhering to the surface of the sintered nickel-silicon alloy, thus ensuring the cleanliness of the nickel-silicon alloy and thereby improving the bonding strength with the copper layer.

In an optional embodiment of the present invention, the specific step of copper electroplating is: placing the TOPCon cell substrate, after oxide layer removal, into a copper electroplating solution and applying a current for electroplating.

The copper electroplating solution includes, by weight part, 1-10 parts of copper salt, 0.5-3 parts of acid, and 20-40 parts of water. The copper salt includes copper sulfate and copper chloride, and the weight ratio of copper sulfate to copper chloride can be (400-600): (0.1-0.5). The acid can be sulfuric acid.

In the present invention, the process parameters for copper electroplating are: a current density of 5A/dm²-10A/dm², and an electroplating time of 5min-10min.

In an optional embodiment of the present invention, the specific step of silver electroplating is: placing the copper-plated TOPCon cell substrate into a silver electroplating solution and applying current for electroplating.

The silver electroplating solution includes, by weight part, 0.1-1 part of silver salt, 0.5-3 parts of acid, 0.5-5 parts of ammonium salt, and 20-40 parts of water. The silver salt can be silver nitrate, and the acid can be sulfosalicylic acid.

In the present invention, the process parameter for silver electroplating is: a current density of 1A/dm²-2A/dm².

In an optional embodiment of the present invention, the preparation method for a TOPCon cell includes the following steps.

S1 Coating: coating both sides of the silicon substrate to form a silicon nitride coating layer, and then removing the coating layer on the surface of the silicon substrate using a laser grooving method to form patterned grooves on the surface of the coating layer.

S2 Pre-treatment: sequentially performing degreasing cleaning, oxide layer removal, and activation treatment on the patterned grooves of the silicon substrate to obtain a pretreated TOPCon solar cell substrate.

S3 Chemical nickel-plating: placing the pretreated TOPCon solar cell substrate in a chemical nickel-plating solution for heat treatment to form a nickel-plating layer.

S4 Sintering: perform high-temperature sintering on the nickel-plated TOPCon solar cell substrate to form a nickel-silicon alloy layer.

S5 Oxide layer removal: soaking the sintered TOPCon solar cell substrate in an oxide layer removal solution to remove the oxide layer.

S6 Copper electroplating: placing the TOPCon cell substrate, after oxide layer removal, into a copper electroplating solution and applying current for electroplating.

S7 Silver electroplating: placing the copper-plated TOPCon cell substrate into a silver electroplating solution and applying current for electroplating to obtain the TOPCon cell.

In order to contribute to a clearer understanding of the present invention, it is described in detail below in connection with specific examples. However, these examples are merely exemplary and do not constitute any limitation on the scope of the present invention.

FIG 1 is a process flow of the preparation method for a TOPCon cell. As shown in FIG 1, the method includes the following steps: S1 Coating; S2 Pre-treatment: sequentially performing degreasing, oxide layer removal, and activation treatment on the patterned grooves of the silicon substrate to obtain the pretreated TOPCon solar cell substrate; S3 Chemical nickel-plating, S4 Sintering, S5 Oxide layer removal, S6 Copper electroplating, and S7 Silver electroplating, thus obtaining the TOPCon cell.

Example 1

The present example provides a preparation method for a TOPCon cell, and the preparation method includes the following steps:
S1 Coating: coating both sides of the silicon substrate to form 80 nm silicon nitride coating layers on the front and back surfaces, and then removing the coating layer on the surface of the silicon substrate using a laser grooving method to form patterned grooves on the surface of the coating layer.

The coating was performed using the PECVD method, and the process parameters for coating were: a pressure of 1400 mTorr, a temperature of 400°C, a power of 8000 W, a time at 90 s, a pulse on-off ratio of 1:8, and an introduced SiH₄/NH₃=1:4.

The patterned grooves were crisscrossed grooves, and the depth of the grooves was 80 nm. The grooves included primary grooves and fine grooves. The width of the primary grooves was 55 µm, and the width of the fine grooves was 12 µm.

S2 Pre-treatment: placing the TOPCon cell substrate with the patterned grooves into a degreasing solution and perform ultrasonic treatment at 35°C and a power of 60W for 60s, followed by deionized water rinsing; placing the degreased TOPCon cell substrate into an oxide layer removal solution, soaking it at 25°C for 60s, and then rinsing with deionized water; and placing the oxide layer-removed TOPCon cell substrate into an activation solution, soaking it at 25°C for 90s, and then rinsing with deionized water to obtain the pretreated TOPCon solar cell substrate.

The degreasing solution was a 10 vol% toluene aqueous solution. The oxide layer removal solution was a mixture of 15 g ammonium fluoride, 60 mL hydrofluoric acid, and 1500 mL deionized water. The activation solution was a mixture of 0.025 g gold chloride and 1500 mL deionized water.

S3 Chemical nickel-plating: placing the pretreated TOPCon solar cell substrate into a chemical nickel-plating solution and reacting it at 95°C for 3 min to form a nickel-plating layer.

The chemical nickel-plating solution was a mixture of 35 g nickel sulfate, 30 g sodium borohydride, 15 g sodium citrate, 100 mL ammonium hydroxide, and 1500 mL deionized water, maintaining a pH of 9.

S4 Sintering: placing the nickel-plated TOPCon cell substrate into an annealing furnace, with a heating rate of 7°C/s, a sintering temperature of 320°C, and a sintering time of 90 s.

S5 Oxide layer removal: placing the sintered TOPCon solar cell substrate into an oxide layer removal solution, soaking it at 25°C for 45 s to remove the oxide layer, and then rinsing with deionized water.

The oxide layer removal solution was a 4 vol% hydrofluoric acid aqueous solution.

S6 Copper electroplating: placing the TOPCon cell substrate, after oxide layer removal, into a copper electroplating solution, applying a current of 7.5 A/dm², and performing electroplating for 7.5 min, followed by deionized water rinsing.

The copper electroplating solution was a mixture of 500 g copper sulfate pentahydrate, 150 g sulfuric acid, 0.25 g copper chloride, and 3000 mL deionized water.

S7 Copper electroplating: placing the copper-plated TOPCon cell substrate into a silver electroplating solution, applying a current of 1.5 A/dm², and performing electroplating for 20 s, followed by deionized water rinsing to obtain the TOPCon cell.

The silver electroplating solution was a mixture of 45 g silver nitrate, 160 g sulfosalicylic acid, 160 g ammonium acetate, and 3000 mL deionized water.

### Example 2

The present example provides a preparation method for a TOPCon battery, and the preparation method includes the following steps:

S1 Coating: coating both sides of the silicon substrate to form 90 nm silicon nitride coating layers on the front and back surfaces, and then removing the coating layer on the surface of the silicon substrate using a laser grooving method to form patterned grooves on the surface of the coating layer.

The coating was performed using the PECVD method, and the process parameters for coating were: a pressure of 1500 mTorr, a temperature of 430°C, a power of 9000 W, a time at 100 s, a pulse on-off ratio of 1:9, and an introduced SiH₄/NH₃=1:6.

The patterned grooves were crisscrossed grooves, and the depth of the grooves was 90 nm. The grooves included primary grooves and fine grooves. The width of the primary grooves was 50 µm, and the width of the fine grooves was 10 µm.

S2 Pre-treatment: placing the TOPCon cell substrate with the patterned grooves into a degreasing solution and perform ultrasonic treatment at 30°C and a power of 80W for 120s, followed by deionized water rinsing; placing the degreased TOPCon cell substrate into an oxide layer removal solution, soaking it at 28°C for 30 s, and then rinsing with deionized water; and placing the oxide layer-removed TOPCon cell substrate into an activation solution, soaking it at 28°C for 60 s, and then rinsing with deionized water to obtain the pretreated TOPCon solar cell substrate.

The degreasing solution was a 5 vol% aqueous acetone solution. The oxide layer removal solution was a mixture of 10 g ammonium fluoride, 40 mL hydrofluoric acid, and 1000 mL deionized water. The activation solution was a mixture of 0.01 g palladium chloride and 1000 mL deionized water.

S3 Chemical nickel-plating: placing the pretreated TOPCon solar cell substrate into a chemical nickel-plating solution and reacting it at 90°C for 5 min to form a nickel-plating layer.

The chemical nickel-plating solution was a mixture of 50 g nickel chloride, 50 g sodium hypophosphite, 20 g sodium citrate, 150 mL ammonium hydroxide, and 2000 mL deionized water, maintaining a pH of 9.5.

S4 Sintering: placing the nickel-plated TOPCon cell substrate into an annealing furnace, with a heating rate of 5°C/s, a sintering temperature of 280°C, and a sintering time of 120 s.

S5 Oxide layer removal: placing the sintered TOPCon solar cell substrate into an oxide layer removal solution, soaking it at 28°C for 30 s to remove the oxide layer, and then rinsing with deionized water.

The oxide layer removal solution was a 2 vol% aqueous sulfuric acid solution.

S6 Copper electroplating: placing the TOPCon cell substrate, after oxide layer removal, into a copper electroplating solution, applying a current of 5 A/dm², and performing electroplating for 10 min, followed by deionized water rinsing.

The copper electroplating solution was a mixture of 400 g copper sulfate pentahydrate, 100 g sulfuric acid, 0.1 g copper chloride, and 2000 mL deionized water.

S7 Copper electroplating: placing the copper-plated TOPCon cell substrate into a silver electroplating solution, applying a current of 1 A/dm², and performing electroplating for 30 s, followed by deionized water rinsing to obtain the TOPCon cell.

The silver electroplating solution was a mixture of 30 g silver nitrate, 120 g sulfosalicylic acid, 120 g ammonium acetate, and 2000 mL deionized water.

### Example 3

The present example provides a preparation method for a TOPCon battery, and the preparation method includes the following steps:
S1 Coating: coating both sides of the silicon substrate to form 100 nm silicon nitride coating layers on the front and back surfaces, and then removing the coating layer on the surface of the silicon substrate using a laser grooving method to form patterned grooves on the surface of the coating layer.

The coating was performed using the PECVD method, and the process parameters for coating were: a pressure of 1800 mTorr, a temperature of 480°C, a power of 12000 W, a time at 120 s, a pulse on-off ratio of 1:10, and an introduced SiH₄/NH₃=1:6.

The patterned grooves were crisscrossed grooves, and the depth of the grooves was 100 nm. The grooves included primary grooves and fine grooves. The width of the primary grooves was 60 µm, and the width of the fine grooves was 15 µm.

S2 Pre-treatment: placing the TOPCon cell substrate with the patterned grooves into a degreasing solution and perform ultrasonic treatment at 40°C and a power of 100W for 30s, followed by deionized water rinsing; placing the degreased TOPCon cell substrate into an oxide layer removal solution, soaking it at 35°C for 90 s, and then rinsing with deionized water; and placing the oxide layer-removed TOPCon cell substrate into an activation solution, soaking it at 35 °C for 120 s, and then rinsing with deionized water to obtain the pretreated TOPCon solar cell substrate.

The degreasing solution was a 20 vol% aqueous ethanol solution. The oxide layer removal solution was a mixture of 20 g ammonium fluoride, 80 mL hydrofluoric acid, and 2000 mL deionized water. The activation solution was a mixture of 0.05 g platinum chloride and 2000 mL deionized water.

S3 Chemical nickel-plating: placing the pretreated TOPCon solar cell substrate into a chemical nickel-plating solution and reacting it at 100°C for 2 min to form a nickel-plating layer.

The chemical nickel-plating solution was a mixture of 25 g nickel aminosulfonate, 25 g borane, 10 g sodium citrate, 50 mL ammonium hydroxide, and 1000 mL deionized water, maintaining a pH of 8.5.

S4 Sintering: placing the nickel-plated TOPCon cell substrate into an annealing furnace, with a heating rate of 10°C/s, a sintering temperature of 360°C, and a sintering time of 60 s.

S5 Oxide layer removal: placing the sintered TOPCon solar cell substrate into an oxide layer removal solution, soaking it at 35°C for 60 s to remove the oxide layer, and then rinsing with deionized water.

The oxide layer removal solution was a 6 vol% aqueous hydrochloric acid solution.

S6 Copper electroplating: placing the TOPCon cell substrate, after oxide layer removal, into a copper electroplating solution, applying a current of 10 A/dm², and performing electroplating for 5 min, followed by deionized water rinsing.

The copper electroplating solution was a mixture of 600 g copper sulfate pentahydrate, 200 g sulfuric acid, 0.5 g copper chloride, and 4000 mL deionized water.

S7 Copper electroplating: placing the copper-plated TOPCon cell substrate into a silver electroplating solution, applying a current of 2 A/dm², and performing electroplating for 15 s, followed by deionized water rinsing to obtain the TOPCon cell.

The silver electroplating solution was a mixture of 60 g silver nitrate, 200 g sulfosalicylic acid, 200 g ammonium acetate, and 4000 mL deionized water.

### Example 4

The present example provides a preparation method for a TOPCon cell. The only difference from Example 1 is that in step S3, the chemical nickel-plating reaction occurred at 85°C for 15 min. All other steps are identical to those in Example 1.

### Example 5

The present example provides a preparation method for a TOPCon cell. The only difference from Example 1 is that in step S3, the chemical nickel-plating reaction occurred at 105°C for 1 minute. All other steps are identical to those in Example 1.

### Example 6

The present example provides a preparation method for a TOPCon cell. The only difference from Example 1 is that the reducing agent was replaced with an equal mass of formaldehyde, sodium citrate was replaced with an equal mass of citric acid, and ammonium hydroxide was replaced with an equal volume of 25 vol% triethylamine aqueous solution. All other steps are identical to those in Example 1.

### Example 7

The present example provides a preparation method for a TOPCon cell. The only difference from Example 1 is that in step S4, the heating rate was set to 4°C/s, the sintering temperature was set to 380°C, and the sintering time was set to 40 s. All other steps are identical to those in Example 1.

### Example 8

The present example provides a preparation method for a TOPCon cell. The only difference from Example 1 is that in step S4, the heating rate was set to 12°C/s, the sintering temperature was set to 260°C, and the sintering time was set to 180 s. All other steps are identical to those in Example 1.

### Comparative Example 1

The present example provides a preparation method for a TOPCon cell. The only difference from Example 1 is that the pre-treatment step S2 was omitted. All other steps are identical to those in Example 1.

### Comparative Example 2

The present example provides a preparation method for a TOPCon cell. The only difference from Example 1 is that in step S3, electroplating nickel was performed by placing the pretreated TOPCon solar cell substrate into an electroplating nickel solution, applying a current of 1 A/dm², and performing electroplating for 5 min, followed by deionized water rinsing to obtain the TOPCon cell. The electroplating nickel solution was a mixture of 150 g nickel sulfate, 20 g sodium chloride, 30 mL boric acid, and 1000 mL deionized water. All other steps are identical to those in Example 1.

### Comparative Example 3

The present example provides a preparation method for a TOPCon cell. The only difference from Example 1 is that the sintering step S4 was omitted. All other steps are identical to those in Example 1.

### Comparative Example 4

The present example provides a preparation method for a TOPCon cell. The only difference from Example 1 is that the oxide layer removal step S5 was omitted. All other steps are identical to those in Example 1.

### Experimental Example 1

### Adhesion Testing

Test samples were the TOPCon cells prepared in Examples 1-8 and Comparative Examples 1-4.

Testing methods were as follows: (1) adhesion between coating and silicon substrate: tested by the 3M tape; (2) welding tension at low temperatures: tested by the tensiometer.

The specific test results are shown in Table 1.

**Table 1**

| Samples | Adhesion between coating and silicon substrate | Welding tension at low temperatures (180-200°C) |
|---|---|---|
| Example 1 | no delamination | average strength of 1.5 N at 12 points |
| Example 2 | no delamination | average strength of 1.6 N at 12 points |
| Example 3 | no delamination | average strength of 1.8 N at 12 points |
| Example 4 | no delamination | average strength of 1.1 N at 12 points |
| Example 5 | no delamination | average strength of 1.2 N at 12 points |
| Example 6 | no delamination | average strength of 1.0 N at 12 points |
| Example 7 | no delamination | average strength of 1.4 N at 12 points |
| Example 8 | no delamination | average strength of 0.8 N at 12 points |
| Comparative Example 1 | delamination | average strength of 0.1 N at 12 points |
| Comparative Example 2 | no delamination | average strength of 0.6 N at 12 points |
| Comparative Example 3 | delamination | average strength of 0.3 N at 12 points |
| Comparative Example 4 | delamination | average strength of 0.2 N at 12 points |

According to the test data in Table 1, the TOPCon solar cells prepared by the preparation method for the present invention all can pass the 3M tape test for adhesion between the coating and the silicon substrate. The welding tension under low-temperature conditions is above 0.8 N. Examples 1-3 are preferred technical solutions, where the welding tension under low-temperature conditions is above 1.5 N. This indicates that the nickel layer obtained through chemical nickel-plating using the preparation method for the present invention has a uniform thickness and low internal stress, thereby forming a strong nickel-silicon alloy after sintering. Subsequently, copper and silver are electroplated, so that the entire nickel-copper-silver coating has good adhesion to the silicon substrate, thus allowing welding pull strength to meet the requirements.

### Experimental Example 2

### Electrical Performance Testing

Test samples were the TOPCon cells prepared in Examples 1-8.

The testing method was as follows. The electrical performance testing of the cells obtained in Example 1 was conducted using the IV testing method (test conditions: 25°C, AM1.5G).

The specific test results are shown in Table 2.

**Table 2**

| Samples | series resistance (Ω) | open-circuit voltage (mV) | short-circuit current (mA) | fill factor F (%) | conversion efficiency (%) |
|---|---|---|---|---|---|
| Example 1 | 0.00045 | 689 | 13.38 | 84.11 | 23.44 |
| Example 2 | 0.00035 | 691 | 13.39 | 84.12 | 23.51 |
| Example 3 | 0.00032 | 690 | 13.36 | 84.33 | 23.52 |
| Example 4 | 0.00085 | 688 | 13.37 | 83.78 | 23.29 |
| Example 5 | 0.00128 | 684 | 13.33 | 82.80 | 22.81 |
| Example 6 | 0.00098 | 684 | 13.30 | 83.44 | 22.94 |
| Example 7 | 0.00245 | 686 | 13.32 | 80.51 | 22.24 |
| Example 8 | 0.00145 | 689 | 13.35 | 82.07 | 22.81 |

From the data in Table 2, it can be seen that the method of the present invention enhances the conductivity of the TOPCon substrate after nickel-plating, allowing for double-sided electroplating of copper and silver. This effectively reduces the parasitic absorption and short-circuit current density loss of the silicon thin film on the back surface of the TOPCon cell, thus significantly lowering the production cost of the battery cell and improving the conversion efficiency of the cell.

Although specific embodiments have been used to illustrate and describe the present invention, it should be understood that many other changes and modifications can be made without departing from the spirit and scope of the present invention.

## Claims

1. A preparation method for a TOPCon cell, wherein the preparation method for the TOPCon cell comprises following steps:
sequentially performing chemical nickel-plating, sintering, oxide layer removal, copper electroplating, and silver electroplating on a TOPCon solar cell substrate to obtain a TOPCon solar cell.

2. The preparation method according to claim 1, wherein the TOPCon solar cell substrate comprises a silicon substrate and a coating layer deposited on a surface of the silicon substrate, wherein a surface of the coating layer is provided with patterned grooves, the coating layer is a silicon nitride film,
a thickness of the silicon nitride film is 80nm-100nm, and
a depth of the grooves is 80nm-100nm, and a width of the grooves is 10µm-60µm.

3. The preparation method according to claim 1, wherein a preparation method for the TOPCon solar cell substrate comprises following steps:
(a) coating both sides of the silicon substrate to form coating layers, and then removing the coating layers on a surface of the silicon substrate using a laser grooving method to form patterned grooves on a surface of the coating layers; and
(b) sequentially performing degreasing cleaning, oxide layer removal, and activation treatment on the patterned grooves of the silicon substrate to obtain a pretreated TOPCon solar cell substrate.

4. The preparation method according to claim 3, wherein in step (a), a coating method is PECVD method; and
process parameters of the PECVD method are as follows:
a pressure of 1400mTorr-1800mTorr, a temperature of 400°C-500°C, a power of 8000W-12000W, a time of 90s-120s, a pulse on-off ratio of 1: (8-10), and a volume ratio of SiH₄ to NH₃ of 1: (4-8).

5. The preparation method according to claim 3, wherein in step (b), a degreasing cleaning method comprises following steps:
placing the TOPCon cell substrate with the patterned grooves into a degreasing solution for ultrasonic treatment, wherein
a volume percentage content of a degreasing agent in the degreasing solution is 5%-20%, and
the degreasing agent comprises at least one of toluene, acetone, and ethanol; and
process parameters for the ultrasonic treatment are as follows:
an ultrasonic temperature of 30°C-40°C, an ultrasonic time of 30s-120s, and an ultrasonic power of 60W-120W.

6. The preparation method according to claim 3, wherein in step (b), an oxide layer removal method comprises following steps:
soaking a degreased TOPCon cell substrate in an oxide layer removal solution, wherein
the oxide layer removal solution comprises following components by weight part:
0.1-5 parts of ammonium fluoride, 1-10 parts of hydrofluoric acid, and 100-200 parts of water; and
a soaking temperature in the oxide layer removal solution is 25°C-35°C, and a soaking time is 30s-90s.

7. The preparation method according to claim 3, wherein in step (b), an activation treatment method comprises following steps:
soaking a TOPCon cell substrate, after the oxide layer removal, in an activation solution, wherein
the activation solution comprises following components by weight part:
0.001-0.005 parts of activator, and 100-200 parts of water;
the activator is a noble metal chloride;
the noble metal chloride is selected from at least one of gold chloride, palladium chloride, and platinum chloride; and
a soaking temperature in the activation solution is 25°C-35°C, and a soaking time is 60s-120s.

8. The preparation method according to claim 1, wherein a chemical nickel-plating method comprises following steps:
placing the TOPCon solar cell substrate in a chemical nickel-plating solution for heat treatment, wherein
a heat treatment temperature is 90°C-100°C, and a heat treatment time is 2min-5min; and
the chemical nickel-plating solution comprises following components by weight part:
1-5 parts of nickel salt, 1-5 parts of reducing agent, 5-20 parts of complexing agent, and 100-200 parts of water;
the nickel salt is selected from at least one of nickel sulfate, nickel chloride, and nickel aminosulfonate;
the reducing agent is selected from at least one of sodium hypophosphite, sodium borohydride, and borane;
the complexing agent comprises sodium citrate and ammonium hydroxide, wherein a mass ratio of the sodium citrate to the ammonium hydroxide is (1-2): (5-15); and
a pH value of the chemical nickel-plating solution is 8.5-9.5.

9. The preparation method according to claim 1, wherein process parameters for the sintering are as follows:
a heating rate of 5°C/s-10°C/s, a sintering temperature of 280°C-360°C, and a sintering time of 60s-120s.

10. The preparation method according to claim 1, wherein an oxide layer removal method comprises following steps:
soaking a sintered TOPCon solar cell substrate in an oxide layer removal solution, wherein
the oxide layer removal solution is an aqueous acid solution, and an acid percentage content in the aqueous acid solution is 2%-6% by volume;
the acid is selected from at least one of hydrofluoric acid, sulfuric acid, hydrochloric acid, and nitric acid; and
a soaking temperature is 25°C-35°C, and a soaking time is 30s-60s.

11. The preparation method according to claim 1, wherein a copper electroplating method comprises following steps:
placing a TOPCon cell substrate, after the oxide layer removal, into a copper electroplating solution and applying a current for copper electroplating, wherein
the copper electroplating solution comprises following components by weight part:
1-10 parts of copper salt, 0.5-3 parts of acid, and 20-40 parts of water; and
the copper salt comprises copper sulfate and copper chloride, and a mass ratio of the copper sulfate to the copper chloride is (400-600): (0.1-0.5); and
the acid is sulfuric acid.

12. The preparation method according to claim 11, wherein process parameters for the copper electroplating are as follows:
a current density of 5A/dm²-10A/dm², and an electroplating time of 5min-10min.

13. The preparation method according to claim 1, wherein a silver electroplating method comprises following steps:
placing a copper-plated TOPCon cell substrate into a silver electroplating solution and applying a current for silver electroplating.

14. The preparation method according to claim 13, wherein the silver electroplating solution comprises following components by weight part:
0.1-1 part of silver salt, 0.5-3 parts of acid, 0.5-5 parts of ammonium salt, and 20-40 parts of water;
the silver salt is silver nitrate; and
the acid is sulfosalicylic acid.

15. The preparation method according to claim 14, wherein process parameters for the silver electroplating are as follows:
a current density of 1A/dm²-2A/dm², and an electroplating time of 15s-30s.

16. A TOPCon cell, wherein the TOPCon cell is prepared by the preparation method according to any one of claims 1-15.
